Europäisches Patentamt

European Patent Office

Office européen des brevets

(11) Publication number: **0 332 313**
**A2**

## (12) EUROPEAN PATENT APPLICATION

(21) Application number: **89301617.0**

(22) Date of filing: **20.02.89**

(51) Int. Cl.⁴: **H01L 23/40**

(30) Priority: **20.02.88 GB 8803991**

(43) Date of publication of application:
**13.09.89 Bulletin 89/37**

(84) Designated Contracting States:
**DE FR IT**

(71) Applicant: **FKI CABLEFORM LIMITED**
**Gratrix Works Gratrix Lane**
**Sowerby Bridge, HX6 2PH(GB)**

(72) Inventor: **Morton, John**
**33 Dean Lane Hazel Grove Stockport**
**Cheshire(GB)**
Inventor: **MacGregor, Malcolm William**
**117 George Lane Bredbury Stockport**
**Cheshire SK6 1DH(GB)**

(74) Representative: **Stanley, David William et al**
**APPLEYARD LEES & CO. 15 Clare Road**
**Halifax**
**West Yorkshire HX1 2HY(GB)**

(54) Semiconductor heat sink assembly.

(57) A semiconductor heat sink assembly comprises a heat sink base 1 and a pair of heat sink clamping blocks 4 which are secured in the base 1 by means of a cured resin of good electrical resistance and good thermal conductivity, in such a position as to clamp a semiconductor device between opposing faces of the clamping blocks 4.

FIG. 2

EP 0 332 313 A2

# SEMICONDUCTOR HEAT SINK ASSEMBLY

This invention relates to heat sink assemblies for semiconductor devices. For many years, semiconductor devices have been provided with heat sinks, to dissipate thermal energy produced by the devices in use, and thereby reduce the risk of damage to the devices, due to overheating.

Overheating can be a particularly acute potential problem with high power semiconductor devices, and as devices of ever increasing power are produced, then so more substantial heat sinks are also required.

In addition to providing heat sinks to semiconductor devices, it is of course necessary also to provide electrical connections thereto, and where the semiconductor devices are designed to pass high current, the connections to be made can be quite substantial.

Typical heat sink and/or connector arrangements for high power semiconductor devices comprise an assembly of various parts, which are usually connected together by nuts, bolts, etc. Usually, such assemblies have a high metal content, to provide satisfactory heat sinks, and it will be appreciated that such metal parts will have an appreciable coefficient of thermal expansion, which is certainly much different to that of the semiconductor device itself. Thus, especially where a semiconductor device is clamped between substantial metal parts, problems can arise of potential mechanical damage to the semiconductor device, as the metal parts move with changes in temperature. Considerable design work is usually entailed, to meet the design problems.

The present invention aims to provide a semiconductor heat sink assembly of generally improved and relatively simple design.

According to one aspect of the present invention, there is provided a semiconductor heat sink assembly comprising a heat sink base, a semiconductor device, and a heat sink clamping block, the clamping block being secured to the base by means of a cured resin of good electrical resistance and good thermal conductivity, in such a position as to bear against one face of the semiconductor thereby to clamp it in a desired position.

Preferably, there are provided two heat sink clamping blocks as aforesaid, each secured to the base by said resin to bear against opposite faces of the semiconductor device, and thereby clamp the device between said blocks.

Preferably, said base defines a channel within which the or each said block is secured. The channel is preferably open ended, either at one or both ends.

In another aspect, the invention provides a method of securing a semiconductor device to a heat sink, comprising the steps of positioning a heat sink clamping block on a heat sink base with a resin of good electrical resistance and good thermal conductivity disposed between said block and base, and allowing the resin to cure so as to secure said block in said base in such a position as to bear against one face of the semiconductor device to clamp it in a desired position.

Preferably two bases as aforesaid are disposed in said heat sink base with said resin between said blocks and said base, and the resin is allowed to cure with said blocks in such a position as to bear against opposite faces of the semiconductor device and thereby clamp the semiconductor device between said blocks. It is further preferred that the or each block is clamped in its desired position by clamping means, during setting of the resin.

According to another preferred feature, the resin is allowed to cure with the or each said block bearing against a spacer, the or each said block is forced away from its clamping position after setting of the resin, the spacer is thereafter removed, and the semiconductor device is inserted in place of the spacer.

For a better understanding of the invention and to show how the same may be carried into effect, reference will now be made, by way of example, to the accompanying diagrammatic drawing, in which:

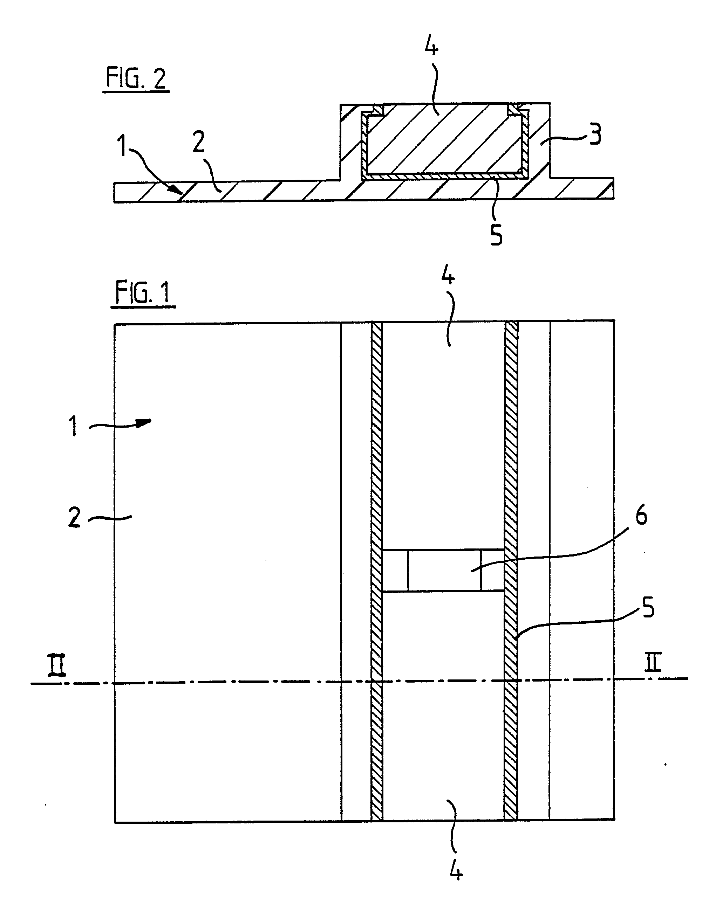

Figure 1 illustrates a semiconductor heat sink assembly in plan view; and

Figure 2 is a cross-section on the line II-II of Figure 1.

The illustrated heat sink assembly comprises a heat sink base 1 which is formed as an extrusion of a metal of good thermal conductivity (e.g. aluminium). The base has a substantially flat mounting/heat dissipation area 2, and a generally C-shaped channel 3, which is open at both ends. Disposed within the channel 3 are a pair of heat sink blocks 4, which are also extruded of metal of good thermal conductivity, and are secured within the channel 3 by means of a thin layer of resin 5, which is interposed between the blocks 4 and the channel 3, thereby to isolate the blocks from the channel. The resin 5 is preferably of high electrical resistivity and high thermal conductivity (for example, of at least 4 Kw/m °C).

The heat sink blocks 4 are so secured in the channel 3 by means of the resin 5, as to clamp therebetween a semiconductor device 6, opposing faces of which are borne against by contacting faces of the heat sink blocks 4.

Thus, the blocks 4 make good electrical and thermal contact with the semiconductor device 6. Therefore, the blocks 4 may serve not only to conduct heat away from the semiconductor device 6, but also to afford reliable electrical connectors therefor. To this end, the blocks 4 may be formed or provided with suitable means for affording external electrical connections.

Heat that is transferred to the blocks 4 from the semiconductor device 6 is subsequently dissipated into the heat sink base, via the resin layer 5.

It will be appreciated that, in the illustrated diagram, the surface area of the resin layer 5 is substantial, whereas its thickness is relatively small (e.g. 2 mm). Thus, any relative thermal impedance presented by the resin layer may be kept to a minimum. In this regard, it will be appreciated that, although the resin preferably has a relatively high thermal conductivity, this may typically be significantly less than that of the thermal conductivity of the metal base 2 and blocks 4.

The layer of resin 5 serves to mount the blocks 4 securely within the channel 3 of the base 2, whilst retaining a significant clamping force against the opposite faces of the semiconductor device 6. As the temperature of the assembly rises, the heat sink base 2 and blocks 4 will tend to expand. However, relative movement between the blocks 4 and the base 2 is inhibited due to the resin layer, and the characteristics of this layer (e.g. thickness, components of resin, filler size, catalyst, etc) may affect both the initial clamping force that may be applied to the semiconductor device 6, and how this force may vary with temperature.

A first method of forming the illustrated assembly will now be described.

Firstly, the semiconductor device 6 is placed in the channel 3 of the heat sink base 2. The two blocks 4 are then engaged within the channel 3, and brought to bear against the opposite faces of the semiconductor device 6 where they are then held in place by external clamps. Resin is applied between the blocks 4 and the inner walls of the channel 3, and this may be applied either before insertion of the blocks, or after.

The resin is then allowed to cure, whilst the external clamps are maintained in place. Upon full curing of the resin, the clamps are released, and the semiconductor device is then clamped in place between the blocks 4, due to the securing of the blocks 4 within the channel 3, by means of the resin.

It will be appreciated that, upon releasing the external clamping means, the layer of resin 5 may permit a small amount of relative movement between the blocks 4. As indicated above, the characteristics of the resin 5 will determine how much variation in clamping force may be expected, upon removing the clamping means.

In a variation of the above method, a spacer is initially disposed between the two blocks 4, which are again held in position by external clamps, until the resin 5 has fully cured. At this point, the two blocks 4 are spaced apart, the spacer is removed, the semiconductor device 6 is inserted between the blocks 4, and the blocks 4 are released, to clamp the semiconductor device firmly in position.

Thus, it may be appreciated that the illustrated apparatus and above described methods afford a means for readily clamping a semiconductor device in a heat sink assembly, whilst at the same time affording simple and reliable connections to the opposing faces of the semiconductor device. Once the resin 5 has fully cured, no additional securing means are required, other than the resin itself, which provides not only a secure mounting, but also affords a ready means of compensation for thermal expansion.

The invention is not restricted to the details of the foregoing embodiment(s). The invention extends to any novel one, or any novel combination, of the features disclosed in this specification and/or drawings, or to any novel one, or any novel combination, of the steps of any method or process disclosed herein.

## Claims

1. A semiconductor heat sink assembly comprising a heat sink base, a semiconductor device, and a heat sink clamping block, the clamping block being secured to the base by means of a cured resin of good electrical resistance and good thermal conductivity, in such a position as to bear against one face of the semiconductor device thereby to clamp it in a desired position.

2. A semiconductor heat sink assembly according to Claim 1, comprising two heat sink clamping blocks as aforesaid, each secured to the base by said resin to bear against opposite faces of the semiconductor device and thereby clamp the semiconductor device between said blocks.

3. A semiconductor heat sink assembly according to Claim 1 or 2, wherein said base defines a channel within which the or each said block is secured.

4. A semiconductor heat sink assembly according to Claim 3, wherein said channel has at least one open end.

5. A semiconductor heat sink assembly substantially as herein/before described with reference to the accompanying drawing.

6. A method of securing a semiconductor device to a heat sink, comprising the steps of positioning a heat sink clamping block on a heat sink base with a resin of good electrical resistance and good thermal conductivity disposed between said block and base, and allowing the resin to cure so as to secure said block in said base in such a position as to bear against one face of the semiconductor device to clamp it in a desired position.

7. A method according to Claim 6, wherein two bases as aforesaid are disposed in said heat sink base with said resin between said blocks and said base, and the resin is allowed to cure with said blocks in such a position as to bear against opposite faces of the semiconductor device and thereby clamp the semiconductor device between said blocks.

8. A method according to Claim 6 or 7, wherein the or each block is clamped in its desired position by clamping means, during setting of the resin.

9. A method according to Claim 6, 7 or 8, wherein the resin is allowed to cure with the or each said block bearing against a spacer, the or each said block is forced away from its clamping position after setting of the resin, the spacer is thereafter removed, and the semiconductor device is inserted in place of the spacer.

10. A method of securing a semiconductor device to a heat sink, substantially as described herein.

FIG. 2

FIG. 1